# EUROPEAN PATENT APPLICATION

(11) **EP 1 754 772 A1**
(43) Date of publication of application: **21.02.2007**
(21) Application number: 06253858.2
(22) Date of filing: 24.07.2006
(51) Int. Cl.: C10M 169/04, H01L 23/373

(54) **Heat conductive silicone grease composition and cured product thereof**

(30) Priority: 18.08.2005 JP 2005238019
(71) Applicant: Shin-Etsu Chemical Co., Ltd., Tokyo (JP)
(72) Inventor: Endo, Akihiro c/o Silicone D.Z.G.K,Shin-Etsu, Annaka-shi, Gunma-ken (JP); Yamada, Kunihiro c/o Silicone D.Z.G.K,Shin-Etsu, Annaka-shi, Gunma-ken (JP); Kizaki, Hiroaki c/o Silicone D.Z.G.K,Shin-Etsu, Annaka-shi, Gunma-ken (JP); Miyoshi, Kei c/o Silicone D.Z.G.K,Shin-Etsu, Annaka-shi, Gunma-ken (JP)
(74) Representative: Hallybone, Huw George

(57) **Abstract**

Provided is a heat conductive silicone grease composition including (A) 100 parts by mass of an organopolysiloxane containing 2 or more alkenyl groups bonded to silicon atoms within each molecule, (B) an organohydrogenpolysiloxane containing 2 or more hydrogen atoms bonded to silicon atoms within each molecule, in sufficient quantity to provide from 0.1 to 5.0 hydrogen atoms bonded to silicon atoms within the component (B) for each alkenyl group within the component (A), (C) 100 to 2,200 parts by mass of a heat conductive filler, (D) an effective quantity of a platinum-based catalyst, and (E) an effective quantity of an addition reaction retarder, in which the component (C) includes more than 90% by mass and no more than 100% by mass of an indium powder with an average particle size of 0.1 to 100 µm. Also provided is a heat conductive silicone cured product obtained by curing the above composition by heating at a temperature equal to, or greater than, the melting point of the indium powder. Further provided is an electronic device including an electronic component, a heat radiating member, and a heat conductive member including the above cured product disposed between the electronic component and the heat radiating member. Still further provided is a method of curing the above composition. Even further provided is a method of forming a heat conductive member between an electronic component and a heat radiating member. The above heat conductive silicone grease composition generates a suitably thin cured product with excellent thermal conductivity that prevents problems such as the contamination of components other than the coated component, and the leakage of oily materials from the product if used over extended periods.

## Description

### BACKGROUND OF THE INVENTION

### 1. Field of the Invention

The present invention relates to a heat conductive silicone grease composition, a method of curing such a composition, a cured product thereof, an electronic device containing such a cured product, and a method of forming a heat conductive member between an electronic component and a heat radiating member.

### 2. Description of the Prior Art

Electronic components mounted on printed wiring boards, including IC packages such as CPUs, can suffer from deterioration in the component performance or even failure of the component as a result of temperature increases caused by heat generated during operation of the component. Accordingly, a heat conductive sheet with good thermal conductivity or a heat conductive grease is conventionally sandwiched between the IC package and a heat radiating member with heat radiating fins, thereby efficiently conducting the heat generated by the IC package or the like through to the heat radiating member, which then radiates the heat away. However, as the performance of electronic components and the like improves, the quantity of heat generated by the components also tends to increase, meaning there is a demand for the development of materials and members with even better thermal conductivity than conventional materials.

Heat conductive sheets offer workability advantages as they can be easily mounted and installed. Furthermore, heat conductive greases offer other advantages in that they are unaffected by irregularities in the surfaces of the IC package such as a CPU or the heat radiating member, and conform to, and follow these irregularities, meaning the IC package and the heat radiating member can be held together without any intervening gaps, thus ensuring a small interfacial thermal resistance. These heat conductive sheets and heat conductive greases both require the addition of a heat conductive filler in order to achieve thermal conductivity. However, the apparent viscosity of either material must be restricted to a certain upper limit, in order to prevent any obstacles to workability or processability within the production process in the case of a heat conductive sheet, and in order to prevent any workability problems during application by syringe to an electronic component in the case of a heat conductive grease. As a result, there is a limit to how much heat conductive filler can be added to either material, meaning satisfactory thermal conductivity cannot be achieved.

In order to address these problems, methods of blending a low melting point metal into a heat conductive paste (patent reference 1, patent reference 2), and a heat conductive pad comprising an alloy that adopts a liquid state at temperatures lower than 120°C, and a heat conductive, particulate solid (patent reference 3) have been proposed. However, these heat conductive materials that use low melting point metals have a number of drawbacks, including contamination of components other than the coated component, and leakage of oily materials from the composition if used over extended periods.

In addition, a curable material that combines a low melting point metal and a heat conductive filler has also been proposed (patent reference 4). This material aims to achieve superior heat radiating properties by fusion-bonding a melted low melting point metal to a heat generating member, a heat radiating member, and a heat conductive filler, thereby forming a continuous metal phase. When a low melting point metal and another heat conductive filler are used in combination, the thickness of the grease layer must be reduced in order to improve the thermal conductivity of the cured product. As a result, a material with a small average particle size is generally used as the heat conductive filler. However, even if a heat conductive filler with a small average particle size is used, because the heat conductive filler will often incorporate unexpectedly coarse particles, the grease layer formed on the electronic component or the like may not reach the desired degree of thinness. This means that unless large quantities of the low melting point metal and heat conductive filler are included, satisfactory thermal conductivity may not be attainable.
[Patent Reference 1] JP 7-207160
[Patent Reference 2] EP 0 696 630 A2
[Patent Reference 3] CA 2 343 486 A1
[Patent Reference 4] US 2003/0127496 A1

### SUMMARY OF THE INVENTION

Accordingly, an object of the present invention is to provide a suitably thin cured product with excellent thermal conductivity that prevents problems such as the contamination of components other than the coated component, and the leakage of oily materials from the product if used over extended periods, as well as a heat conductive silicone grease composition that generates such a cured product upon curing. Furthermore, another object of the present invention is to provide a method of curing the above composition, an electronic device that comprises the above cured product, and a method of forming a heat conductive member between an electronic component and a heat radiating member.

As a result of intensive investigations aimed at achieving the above objects, the inventors of the present invention discovered that by selecting indium as a low melting point metal with excellent thermal conductivity, and then using, as one component of a composition, a filler comprising either a lone indium powder in which the particle size has been controlled, or a combination of this indium powder and another heat conductive filler in which the particle size has been controlled, a composition could be obtained in which the indium powder, and when used the other heat conductive filler that is used in combination, are dispersed uniformly as fine particles.

Moreover, the inventors also discovered that in those cases where an indium powder is used alone, by conducting heating at a temperature equal to, or greater than, the melting point of the indium powder during the step of heating and curing the composition, liquid indium particles aggregate together and form liquid particles of large particle size, and these liquid indium particles then interconnect, forming a type of heat conductive pathway, and furthermore, they also discovered that by applying a suitable pressure to the composition during the heat treatment, the liquid indium particles are crushed, enabling the formation of a suitably thin layer.

Furthermore, the inventors also discovered that in those cases where a combination of an indium powder and another heat conductive filler is used, by conducting heating at a temperature equal to, or greater than, the melting point of the indium powder, liquid indium particles aggregate together and form liquid particles of large particle size, and then these liquid indium particles either interconnect with each other, or connect with the other heat conductive filler, forming a type of heat conductive pathway, and furthermore, they also discovered that by setting the particle size of the other conductive filler to a specific range, and then applying a suitable pressure to the composition in a similar manner to the case of the lone indium powder, a suitably thin layer could be formed.

Furthermore, they also discovered that the structures of the above heat conductive pathways are fixed and supported within the three dimensional network structure formed upon curing of the composition.

In those cases where a layer of the cured product obtained in the manner described above is sandwiched between an electronic component and a heat radiating member, the inventors also discovered that even if the blend quantity of the indium powder and (in those cases where another heat conductive filler is added) the other heat conductive filler is small, the cured product could still be used as a heat conductive member with low thermal resistance. Accordingly, they found that an electronic component with excellent heat radiating characteristics could be obtained, in which the heat generated during operation of the electronic component could be conducted rapidly through the heat conductive member, which comprises the indium or the combination of the indium and the other heat conductive filler fixed and supported within a three dimensional structure, and then into the heat radiating member.

In other words, a first aspect of the present invention provides a heat conductive silicone grease composition comprising:
(A) 100 parts by mass of an organopolysiloxane containing 2 or more alkenyl groups bonded to silicon atoms within each molecule,
(B) an organohydrogenpolysiloxane containing 2 or more hydrogen atoms bonded to silicon atoms within each molecule, in sufficient quantity to provide from 0.1 to 5.0 hydrogen atoms bonded to silicon atoms within the component (B) for each alkenyl group within the component (A),
(C) 100 to 2,200 parts by mass of a heat conductive filler,
(D) an effective quantity of a platinum-based catalyst, and
(E) an effective quantity of an addition reaction retarder, wherein
   the heat conductive filler of the component (C) comprises more than 90% by mass and no more than 100% by mass of an indium powder with an average particle size of 0.1 to 100 µm.

A second aspect of the present invention provides a heat conductive silicone cured product obtained by curing the above composition by heating at a temperature equal to, or greater than, the melting point of the indium powder.

A third aspect of the present invention provides an electronic device comprising an electronic component, a heat radiating member, and a heat conductive member comprising the above cured product disposed between the electronic component and the heat radiating member.

A fourth aspect of the present invention provides a method of curing the above composition, comprising the step of heating the composition under pressure at a temperature equal to, or greater than, the melting point of the indium powder.

A fifth aspect of the present invention provides a method of forming a heat conductive member between an electronic component and a heat radiating member, comprising the steps of:
(I) applying the above composition to a surface of the electronic component,
(II) mounting the heat radiating member on the applied composition, and
(III) subsequently curing the applied composition by heating under pressure at a temperature equal to, or greater than, the melting point of the indium powder.

A heat conductive silicone grease composition of the present invention exists in a grease form (which includes the case of a paste) prior to curing that exhibits favorable extensibility, and consequently displays favorable workability during application to electronic components such as IC packages. In addition, even if irregularities exist in the surfaces of the electronic component and the heat radiating member, the composition is able to bond the two members tightly together with no intervening gaps, making the occurrence of interfacial thermal resistance unlikely.

A cured product obtained by curing this composition by heating at a temperature equal to, or greater than, the melting point of the indium powder not only exhibits an extremely high level of thermal conductivity, but is also resistant to the problems associated with conventional heat conductive greases, such as the leakage of oily materials from the cured product if used over extended periods, and the contamination of other components. Furthermore, by applying a suitable pressure to the composition during the heating at a temperature equal to, or greater than, the melting point of the indium powder, a suitably thin cured product layer with superior thermal conductivity can be formed.

Accordingly, when a cured product of the present invention is used as the heat conductive member of an electronic device, a superior heat radiating effect can be realized. This enables the reliability of the electronic device to be improved dramatically.

### BRIEF DESCRIPTION OF THE DRAWINGS

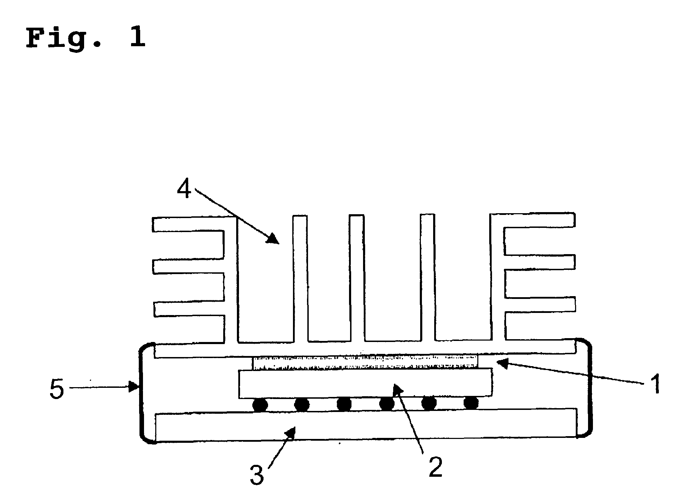

Fig. 1 is a schematic longitudinal cross-sectional view showing one example of a semiconductor device using a composition of the present invention.

### DETAILED DESCRIPTION OF THE PREFERRED EMBODIMENTS

As follows is a more detailed description of the present invention.

### [Heat Conductive Silicone Grease Composition]

A heat conductive silicone grease composition of the present invention comprises the components (A) through (E) described below.

### <(A) Organopolysiloxane>

The component (A) of a composition of the present invention is an organopolysiloxane containing 2 or more alkenyl groups bonded to silicon atoms within each molecule, and is the primary component (the base polymer) within the addition reaction curing system.

There are no particular restrictions on the molecular structure of the organopolysiloxane of the component (A), provided it is liquid at 25°C, and straight chains, branched chains, and straight chains with partial branching are all suitable, although straight-chain structures are particularly preferred.

The alkenyl groups typically contain from 2 to 10, and preferably from 2 to 6, carbon atoms. Examples of such alkenyl groups include vinyl groups, allyl groups, 1-butenyl groups, and 1-hexenyl groups. Of these, vinyl groups, which are very flexible in terms of their use, are preferred. These alkenyl groups may be bonded to the silicon atoms at the molecular chain terminals of the organopolysiloxane, to silicon atoms within the molecular chain (that is, non-terminal silicon atoms), or to both these types of silicon atoms, although in order to ensure good flexibility of the resulting cured product, the alkenyl groups are preferably bonded only to silicon atoms at the molecular chain terminals.

Examples of other organic groups bonded to silicon atoms within the component (A), besides the aforementioned alkenyl groups, include unsubstituted or substituted monovalent hydrocarbon groups of 1 to 12, and preferably 1 to 10, carbon atoms, and specific examples of such groups include alkyl groups such as methyl groups, ethyl groups, propyl groups, butyl groups, pentyl groups, hexyl groups, heptyl groups, octyl groups, nonyl groups, decyl groups and dodecyl groups; cycloalkyl groups such as cyclopentyl groups and cyclohexyl groups; aryl groups such as phenyl groups, tolyl groups, xylyl groups and naphthyl groups; aralkyl groups such as benzyl groups, 2-phenylethyl groups, and 2-phenylpropyl groups; and halogenated alkyl groups such as chloromethyl groups, 3,3,3-trifluoropropyl groups and 3-chloropropyl groups. From the viewpoints of ease of synthesis and economic viability, at least 90 mol%, and preferably 95 mol% or more of these non-alkenyl organic groups bonded to silicon atoms are preferably methyl groups.

The viscosity at 25°C of the organopolysiloxane of the component (A) is typically within a range from 0.05 to 100 Pa·s, and is preferably from 0.5 to 50 Pa·s. If this viscosity is too low, then the storage stability of the obtained composition may deteriorate, whereas if the viscosity is too high, then the extensibility of the obtained composition may worsen.

Examples of the organopolysiloxane of the component (A) include the compounds represented by a general formula (1) shown below: 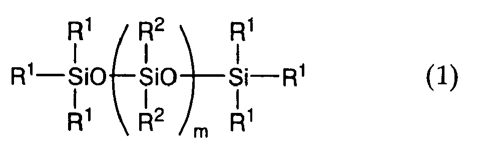 (wherein, each R¹ represents, independently, an unsubstituted or substituted monovalent hydrocarbon group, although at least 2 of these groups are alkenyl groups, each R² represents, independently, an unsubstituted or substituted monovalent hydrocarbon group other than an alkenyl group, and m represents an integer of 1 or greater).

In the above general formula (1), the unsubstituted or substituted monovalent hydrocarbon groups represented by R¹ typically contain from 1 to 12 carbon atoms, and specific examples include the alkenyl groups listed above, and those monovalent hydrocarbon groups listed above amongst the non-alkenyl organic groups bonded to silicon atoms. Examples of the unsubstituted or substituted monovalent hydrocarbon groups other than alkenyl groups represented by R² include those monovalent hydrocarbon groups listed above amongst the non-alkenyl organic groups bonded to silicon atoms.

Furthermore, m is preferably an integer within a range from 50 to 3,000, and even more preferably from 100 to 1,000.

Specific examples of preferred forms of the organopolysiloxane of the component (A) include polydimethylsiloxane with both molecular chain terminals blocked with dimethylvinylsiloxy groups, polydimethylsiloxane with both molecular chain terminals blocked with methyldivinylsiloxy groups, and copolymers of dimethylsiloxane and methylphenylsiloxane with both molecular chain terminals blocked with dimethylvinylsiloxy groups.

This organopolysiloxane of the component (A) may use either a single material, or a combination of two or more different materials (for example, two or more materials with different viscosities).

### <(B) Organohydrogenpolysiloxane>

The component (B) of a composition of the present invention is an organohydrogenpolysiloxane containing 2 or more, and preferably from 2 to 100, hydrogen atoms bonded to silicon atoms (namely, "SiH groups") within each molecule, which functions as a cross-linking agent for the component (A). In other words, under the action of the platinum-based catalyst of the component (D) described below, the hydrogen atoms bonded to silicon atoms within the component (B) undergo addition via a hydrosilylation reaction with the alkenyl groups of the component (A), thereby forming a cross-linked cured product comprising a three dimensional network structure containing cross-linked bonds.

Examples of organic groups that are bonded to silicon atoms within the component (B) include unsubstituted or substituted monovalent hydrocarbon groups other than alkenyl groups, and specific examples include the same groups as the non-alkenyl organic groups bonded to silicon atoms described above in relation to the component (A). Of these, from the viewpoints of ease of synthesis and economic viability, methyl groups are preferred.

There are no particular restrictions on the structure of the organohydrogenpolysiloxane of the component (B), and straight chains, branched chains, and cyclic structures are all suitable, although straight-chain structures are particularly preferred.

Examples of the organohydrogenpolysiloxane of the component (B) include compounds represented by a general formula (2) shown below: 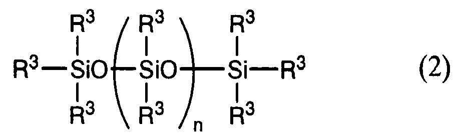 (wherein, each R³ represents, independently, an unsubstituted or substituted monovalent hydrocarbon group other than an alkenyl group, or a hydrogen atom, although at least 2 of these groups are hydrogen atoms, and n represents an integer of 1 or greater).

In the above general formula (2), the unsubstituted or substituted monovalent hydrocarbon groups other than alkenyl groups represented by R³ include those monovalent hydrocarbon groups listed above amongst the non-alkenyl organic groups bonded to silicon atoms described in relation to the component (A).

Furthermore, n is preferably an integer within a range from 2 to 100, and even more preferably from 5 to 50.

Specific examples of preferred organohydrogenpolysiloxanes that can be used as the component (B) include methylhydrogenpolysiloxane with both molecular chain terminals blocked with trimethylsiloxy groups, copolymers of dimethylsiloxane and methylhydrogensiloxane with both molecular chain terminals blocked with trimethylsiloxy groups, copolymers of dimethylsiloxane, methylhydrogensiloxane and methylphenylsiloxane with both molecular chain terminals blocked with trimethylsiloxy groups, dimethylpolysiloxane with both molecular chain terminals blocked with dimethylhydrogensiloxy groups, copolymers of dimethylsiloxane and methylhydrogensiloxane with both molecular chain terminals blocked with dimethylhydrogensiloxy groups, copolymers of dimethylsiloxane and methylphenylsiloxane with both molecular chain terminals blocked with dimethylhydrogensiloxy groups, and methylphenylpolysiloxane with both molecular chain terminals blocked with dimethylhydrogensiloxy groups. Furthermore, the organohydrogenpolysiloxane of the component (B) may use either a single material, or a combination of two or more different materials.

The blend quantity of the component (B) is sufficient to provide from 0.1 to 5.0, and preferably from 0.5 to 3.0, hydrogen atoms bonded to silicon atoms within this component for each alkenyl group within the component (A). If this number is less than 0.1, then a satisfactory three dimensional network structure is not formed, meaning the required level of hardness is not achieved following curing, and increasing the likelihood that the heat conductive filler described below will be unable to be fixed and supported within the cured product. In contrast, if the number exceeds 5.0, then the variation over time in the physical properties of the resulting cured product tends to increase, and the storage stability may deteriorate.

### <(C) Heat Conductive Filler>

The component (C) of a composition of the present invention is a heat conductive filler, which is blended into the composition to impart favorable thermal conductivity to the cured product.

### - (C-1) Indium Powder -

The heat conductive filler of the component (C) comprises an indium powder (C-1) with an average particle size of 0.1 to 100 µm. There are no particular restrictions on the shape of the indium powder, and the aspect ratio is typically within a range from 1.0 to 5.0, and preferably from 1.0 to 3.0, whereas the flatness ratio is typically within a range from 0.01 to 200, and preferably from 0.1 to 100. The aspect ratio is the value defined by the equation [aspect ratio] = [major axis of powder] / [minor axis of powder], whereas the flatness ratio is the value defined by the equation [flatness ratio] = [minor axis of powder] / [thickness of powder]. Furthermore, the shapes of individual particles within the indium powder of the component (C-1) may be completely uniform, substantially uniform, or lacking in uniformity, and the powder may also include irregular particles. Specific examples of suitable shapes for the indium powder of the component (C-1) include spherical shapes (including perfect spheres, and substantially spherical shapes such as pseudo-spheres, elliptical spheres and flattened spheres), scale-like shapes, needle shapes, clumps, and rod-like shapes.

The average particle size of the indium powder is preferably within a range from 5 to 50 µm, and even more preferably from 10 to 30 µm. If this average particle size is less than 0.1 µm, then the viscosity of the composition becomes overly high, yielding a composition with poor extensibility that can cause problems in terms of ease of application, whereas if the average particle size exceeds 100 µm, the composition may lose uniformity, and the indium powder may settle out, making application of a uniform thin film of the composition to an electronic component or the like very difficult. In this description, the term "average particle size" refers to the cumulative average size on a volume basis. This "average particle size" can be measured, for example, using a particle size analyzer (brand name: Microtrac MT3300EX, manufactured by Nikkiso Co., Ltd. The indium powder (C-1) contained within the component (C) must represent more than 90% by mass and no more than 100% by mass of the entire component (C), and this proportion is preferably within a range from 91 to 100% by mass, and even more preferably from 92 to 100% by mass. If this proportion is 90% by mass or less, then aggregation between the indium particles and interconnection with the other heat conductive filler does not proceed adequately when the powder is heated and converted to liquid form, meaning the formation of heat conductive pathways may not progress satisfactorily.

### - (C-2) Other Heat Conductive Filler -

In addition to the indium powder (C-1), the component (C) may also contain another heat conductive filler (C-2), and specifically, may contain more than 0% by mass but less than 10% by mass, and preferably more than 0% by mass but no more than 9% by mass, of a heat conductive filler that has an average particle size within a range from 0.1 to 20 µm, a sieve retention ratio for a 32 µm mesh prescribed in JIS Z8801-1 of no more than 50 ppm, and a sieve retention ratio for a 45 µm mesh prescribed in JIS Z8801-1 that is effectively 0 ppm.

The average particle size is preferably within a range from 1 to 10 µm, and even more preferably from 1 to 5 µm. If this average particle size is too small, then the viscosity of the composition may become overly high, causing poor extensibility. If the average particle size is too large, then obtaining a uniform composition becomes difficult.

Furthermore, in this other heat conductive filler of the component (C-2), if the sieve retention ratio for a 32 µm mesh prescribed in JIS Z8801-1 exceeds 50 ppm relative to the total mass of this other heat conductive filler, then the thickness of a cured product layer of the heat conductive silicone grease composition may not be able to be adequately reduced, meaning the desired heat radiating effect may be unobtainable, and as a result, this sieve retention ratio must be restricted to no more than 50 ppm, and is preferably no more than 30 ppm, and even more preferably within a range from 0 to 10 ppm. Furthermore, even if this sieve retention ratio for a prescribed 32 µm mesh is no more than 50 ppm, the existence of a single coarse particle within the composition may still make it impossible to adequately reduce the thickness of a cured product layer of the heat conductive silicone grease composition, meaning the desired heat radiating effect may be unobtainable. Accordingly, in order to achieve the desired heat radiating effect, the sieve retention ratio for a 45 µm mesh prescribed in JIS Z8801-1 must also be effectively 0 ppm.

The manufacturers that produce fillers such as heat conductive fillers measure the particle size distribution, which is then recorded on a test chart or the like, but coarse particles for which the absolute quantity is minimal are generally not detectable by particle size distribution measurement devices. However, the existence of such coarse particles has a significant effect on the layer thickness when the grease is applied, meaning that even if the same material with the same average particle size is used, the resulting heat radiating characteristics vary significantly depending on whether or not these coarse particles have been removed. In recent years, because the quantity of heat generated by electronic components such as elements and the like has increased dramatically, the control of the quantity of these coarse particles within heat conductive fillers has become particularly important. Several methods can be used for removing the coarse particles from heat conductive fillers. Specific examples of these methods include air flow classification methods and mesh classification methods, although any heat conductive filler classification method may be used, provided it enables highly effective removal of coarse particles.

There are no particular restrictions on the other heat conductive filler, provided it offers favorable thermal conductivity, and suitable examples include the types of heat conductive fillers typically blended into conventional heat conductive sheets or heat conductive greases. Specific examples of such fillers include metal powders such as aluminum powder, nickel powder, zinc powder, stainless steel powder, copper powder, and silver powder; metal oxide powders such as alumina powder, and zinc oxide powder; metal nitride powders such as boron nitride powder, aluminum nitride powder, and silicon nitride powder; as well as diamond powder and carbon powder. This other heat conductive filler may use either a single material, or a combination of two or more different materials.

The blend quantity of the component (C) must be within a range from 100 to 2,200 parts by mass per 100 parts by mass of the component (A), and is preferably within a range from 100 to 1,700 parts by mass, even more preferably at least 100 parts by mass but less than 800 parts by mass, and is most preferably within a range from 300 to 700 parts by mass. If this blend quantity is less than 100 parts by mass, then not only is the thermal conductivity of the resulting composition poor, but the storage stability is also poor, whereas if the blend quantity exceeds 2,200 parts by mass, the resulting composition exhibits poor extensibility.

### - Preferred Embodiments -

In a composition of the present invention, the heat conductive filler of the component (C) preferably comprises either solely the component (C-1), or a combination consisting of the component (C-1) and the component (C-2). In such cases, the proportion of the component (C-1) within the component (C) must be more than 90% by mass and no more than 100% by mass of the entire heat conductive filler of the component (C), and in cases where the composition also includes the component (C-2), the proportion of the component (C-2) within the component (C) is preferably more than 0% by mass but less than 10% by mass. Ensuring these proportions are satisfied means that when heat treatment is conducted during curing of the composition, a satisfactory interconnection can be achieved, either within the component (C-1) itself or between the component (C-1) and the component (C-2), and a more favorable aggregation of the liquid fine particles of the component (C-1) can be achieved, thereby enabling the formation of favorable heat conductive pathways within the cured product. As a result, the cured product layer will exhibit superior heat radiating properties.

### <(D) Platinum-based Catalyst>

The platinum-based catalyst of the component (D) of a composition of the present invention accelerates the addition reaction between the alkenyl groups within the component (A) and the hydrogen atoms bonded to silicon atoms within the component (B), and is added to promote the formation of a cross-linked cured product with a three dimensional network structure from the composition of the present invention.

Any of the catalysts typically used in conventional hydrosilylation reactions can be used as this component (D). Specific examples of suitable materials include platinum metal (platinum black), chloroplatinic acid, platinum-olefin complexes, platinum-alcohol complexes and platinum coordination compounds. The platinum-based catalyst of the component (D) may use either a single material, or a combination of two or more different materials.

There are no particular restrictions on the blend quantity of the component (D), which need only be an effective catalytic quantity required to cure the composition of the present invention, although a typical quantity, calculated as the mass of platinum atoms relative to the mass of the component (A), is within a range from 0.1 to 500 ppm.

### <(E) Addition Reaction Retarder>

The addition reaction retarder of the component (E) of a composition of the present invention inhibits the hydrosilylation reaction caused by the action of the platinum-based catalyst from occurring at room temperature, thus enhancing the usable life (the shelf life or pot life) of the composition, and is added to ensure that no problems arise during the application of the composition to an electronic component or the like.

Any of the conventional addition reaction retarders used in typical addition reaction curable silicone compositions can be used as this component (E). Specific examples include acetylene compounds such as 1-ethynyl-1-cyclohexanol and 3-butyn-1-ol, as well as a variety of nitrogen compounds, organophosphorus compounds, oxime compounds, and organochlorine compounds. The addition reaction retarder of the component (E) may use either a single material, or a combination of two or more different materials.

The blend quantity of this component (E) cannot be generalized, and varies depending on the quantity used of the component (D), although any quantity that is effective in inhibiting the progression of the hydrosilylation reaction can be used, and typically, a quantity within a range from 10 to 50,000 ppm relative to the mass of the component (A) is suitable. If the blend quantity of the component (E) is too small, then a satisfactory usable life cannot be ensured, whereas if the quantity is too large, the curability of the composition may deteriorate.

In order to improve the dispersibility within the composition, where required, this component (E) may be diluted with an organic solvent such as toluene, xylene or isopropyl alcohol prior to use.

### <Optional Components>

In addition to the components (A) through (E) described above, other components may also be added to the composition of the present invention, provided such addition does not impair the purpose or effects of the present invention. Examples of such optional components include heat resistance improvers such as iron oxide and cerium oxide; viscosity regulators such as silica; and colorants and the like. Furthermore, a surface treatment agent (F) described below may also be added.

### - (F) Surface Treatment Agent -

A surface treatment agent (F) (a wetter) may also be added to a composition of the present invention, for the purpose of subjecting the indium powder of the component (C-1) to hydrophobic treatment during the preparation of the composition, thereby improving the wettability of the component (C-1) by the organopolysiloxane of the component (A), and enabling the indium powder of the component (C-1) to be dispersed uniformly within the matrix comprising the component (A). In those cases where another heat conductive filler (C-2) is used in addition to the indium powder, then in a similar manner, this component (F) has the effect of improving the wettability of the heat conductive filler (C-2) by the organopolysiloxane of the component (A), thereby ensuring a more favorable uniform dispersion of the filler.

### - (F-1) Alkoxysilane Compound

Examples of the component (F) include the alkoxysilane compounds (F-1) represented by a general formula (3) shown below:

R⁴ₐR⁵_{b}Si(OR⁶)_{4-a-b} (3)

(wherein, each R⁴ represents, independently, an alkyl group of 6 to 15, and preferably from 8 to 14, carbon atoms, each R⁵ represents, independently, an unsubstituted or substituted monovalent hydrocarbon group of 1 to 8, and preferably from 1 to 6, carbon atoms, each R⁶ represents, independently, an alkyl group of 1 to 6, and preferably from 1 to 4, carbon atoms, a represents an integer from 1 to 3, and preferably 1, b represents an integer from 0 to 2, and the sum of a+b is an integer from 1 to 3).

Specific examples of the alkyl groups represented by R⁴ in the above general formula (3) include hexyl groups, octyl groups, nonyl groups, decyl groups, dodecyl groups and tetradecyl groups. Provided the number of carbon atoms of the alkyl groups represented by R⁴ fall within the range from 6 to 15, the wettability of the component (C) improves satisfactorily, and the handling and low-temperature characteristics of the composition are favorable.

Examples of the unsubstituted or substituted monovalent hydrocarbon groups represented by R⁵ include alkyl groups such as methyl groups, ethyl groups, propyl groups, hexyl groups and octyl groups; cycloalkyl groups such as cyclopentyl groups and cyclohexyl groups; alkenyl groups such as vinyl groups and allyl groups; aryl groups such as phenyl groups and tolyl groups; aralkyl groups such as 2-phenylethyl groups and 2-methyl-2-phenylethyl groups; and halogenated hydrocarbon groups such as 3,3,3-trifluoropropyl groups, 2-(nonafluorobutyl)ethyl groups, 2-(heptadecafluorooctyl)ethyl groups and p-chlorophenyl groups. Of these, methyl groups and ethyl groups are particularly preferred.

Examples of the alkyl groups represented by R⁶ include alkyl groups such as methyl groups, ethyl groups, propyl groups, butyl groups, pentyl groups and hexyl groups. Of these, methyl groups and ethyl groups are particularly preferred.

Specific examples of preferred forms of this component (F-1) include the compounds shown below.

C₆H₁₃Si(OCH₃)₃

C₁₀H₂₁Si(OCH₃)₃

C₁₂H₂₅Si(OCH₃)₃

C₁₂H₂₅Si(OC₂H₅)₃

C₁₀H₂₁Si(CH₃)(OCH₃)₂

C₁₀H₂₁Si(C₆H₅)(OCH₃)₂

C₁₀H₂₁Si(CH₃)(OC₂H₅)₂

C₁₀H₂₁Si(CH=CH₂)(OCH₃)₂

C₁₀H₂₁Si(CH₂CH₂CF₃)(OCH₃)₂

This component (F-1) may use either a single compound, or a combination of two or more different compounds. Furthermore, the blend quantity of the component (F-1) is preferably within a range from 0.01 to 20 parts by mass, and even more preferably from 0.1 to 10 parts by mass, per 100 parts by mass of the component (A). If this blend quantity is too large, then no further improvement is seen in the wetting effect, meaning the addition is simply uneconomical, and because the component also exhibits some volatility, the composition of the present invention may gradually cure if left in an open system.

### - (F-2) Dimethylpolysiloxane

Examples of the component (F) other than the aforementioned (F-1) include dimethylpolysiloxanes in which one molecular chain terminal is blocked with a trialkoxysilyl group (F-2), as represented by a general formula (4) shown below: 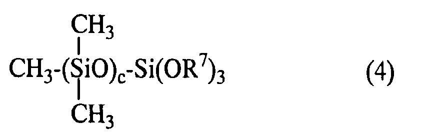 (wherein, each R⁷ represents, independently, an alkyl group of 1 to 6, and preferably from 1 to 4, carbon atoms, and c represents an integer from 5 to 100, and preferably from 10 to 60).

Examples of the alkyl groups represented by R⁷ in the above general formula (4) include the same alkyl groups as those represented by the group R⁶ in the above general formula (3).

Specific examples of preferred forms of this component (F-2) include the compounds shown below.

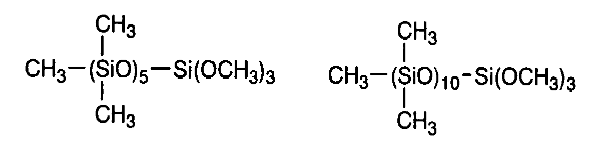

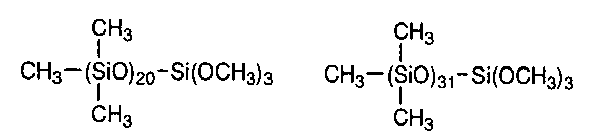

This component (F-2) may use either a single compound, or a combination of two or more different compounds. Furthermore, the blend quantity of the component (F-2) is preferably within a range from 0.01 to 20 parts by mass, and even more preferably from 0.1 to 10 parts by mass, per 100 parts by mass of the component (A). If this blend quantity is too large, then the thermal resistance of the resulting cured product tends to deteriorate.

A combination of the component (F-1) and the component (F-2) may also be used as the surface treatment agent of the component (F). In such cases, the blend quantity of the component (F) is preferably within a range from 0.02 to 40 parts by mass per 100 parts by mass of the component (A).

### <Method of Preparation>

A composition of the present invention is usually prepared using a preparation method that includes the step of mixing the components together at a temperature less than the melting point of the indium powder (C-1) to form a uniform mixture. A particularly preferred preparation method comprises the steps of:
(a) mixing together the component (A), the component (C), and where included the component (F), preferably at a temperature within a range from 40 to 120°C, and even more preferably from 50 to 100°C, thereby forming a uniform mixture, and
(b) adding to this mixture, the component (B), the component (D), the component (E), and where included any other components, and then mixing at a temperature less than the melting point of the indium powder of the component (C-1) to form a uniform mixture.

These steps use a stirring and mixing device such as a conditioning mixer or a planetary mixer equipped with a heating device and, where necessary, a cooling device to effect the mixing.

In the above step (a), the indium powder of the component (C-1) is dispersed uniformly as fine particles within a matrix comprising the component (A).

Because the components (A), (B), (D) and (E) react over time, the step (b) is preferably completed within as short a time as possible, to prevent variations in the makeup of the composition. Following completion of the step (b), the produced composition is typically placed inside a container and immediately stored in a freezer or cold room at a temperature within a range from -30 to -10°C, and preferably from -25 to -15°C. Furthermore, transportation of the composition is also preferably conducted using a vehicle equipped with freezer facilities. By storing and transporting the composition under low temperature conditions in this manner, the composition and dispersion stability of the composition can be maintained, even over extended periods.

### <Viscosity>

A composition of the present invention exists in a grease form (which also includes pastes) at room temperature (25°C). As a result, a composition of the present invention exhibits favorable workability during operations such as application to the surface of electronic components.

Furthermore, a composition of the present invention can also be used, for example, to fill a syringe. Specifically, the composition may be used to fill a syringe, the composition may then be discharged from this syringe and onto the surface of an electronic component such as a CPU or the like to form a coating layer, and a heat radiating member may then be pressed onto this coating layer. Accordingly, the viscosity at 25°C of a composition of the present invention is typically within a range from 10 to 1,000 Pa·s, and preferably from 50 to 400 Pa·s. If this viscosity is too low, then overrun of the liquid occurs during application of the composition, and this can cause workability problems. In contrast, if the viscosity is too high, then extrusion of the composition from the syringe becomes difficult, meaning the efficiency of the application process may deteriorate.

### <Curing Method>

A composition of the present invention can be converted to a cured product by heat curing. This curing is preferably conducted at a temperature equal to, or higher than, the melting point of the indium powder of the component (C-1). The reason for this preference is that upon temperature raising to the temperature conditions required during the curing of the composition, the indium powder of the component (C-1) within the composition is converted to liquid form, and not only do these liquid indium particles aggregate together to form liquid particles of large particle size, but the liquid indium particles then interconnect, forming a type of heat conductive pathway. In those cases where the composition also includes another heat conductive filler (C-2) in addition to the indium powder, the liquid indium particles (C-1) also connect with this other heat conductive filler (C-2), forming a similar type of heat conductive pathway. The cured product is able to conduct heat efficiently along these heat conductive pathways. Furthermore, these heat conductive pathways are fixed and supported within the three dimensional structure of the cured product.

This cured product can be used, for example, as a heat conductive member such as a thin heat conductive layer for effecting the radiation of heat from an electronic component. In addition, by employing a curing method that includes a step of heating the composition under pressure at a temperature equal to, or greater than, the melting point of the indium powder, the cured product can be obtained in the form of a favorably thin layer (with a thickness of no more than 30 µm for example).

The pressure can be applied, for example, by using a method in which the composition is sandwiched between metal plates of aluminum, nickel or copper or the like, and pressure is then applied using a clip or the like, although there are no particular restrictions on the method employed. Furthermore, the pressure applied is typically within a range from 50 to 1,500 kPa, and preferably from 100 to 700 kPa.

### <Thermal Resistance>

The thermal resistance at 25°C of a cured product of the present invention measured by the laser flash method is preferably no more than 6.0 mm²·K/W, and more preferably no more than 4.0 mm²·K/W. If the thermal resistance is within this range, the cured product can efficiently diffuse the heat from an electronic component that generates a large quantity of heat to a heat radiating member. The thermal resistance can be measured by the laser flash method in accordance with ASTM E 1461.

### [Electronic Device]

A composition of the present invention can be used for producing an electronic device such as a semiconductor device with excellent heat radiating characteristics, namely, an electronic device comprising an electronic component such as a heat generating electronic component, a heat radiating member such as a heat spreader, a heat sink or a heat pipe, and a heat conductive member comprising a cured product of a composition of the present invention, which is provided between the electronic component and the heat radiating member. The thickness of the heat conductive member is preferably no more than 30 µm. In order to produce this electronic device, the heat conductive member is preferably generated between the electronic component and the heat radiating member using a method of forming the heat conductive member that comprises the steps of:
(I) applying the composition to the surface of the electronic component,
(II) mounting the heat radiating member on the applied composition, and
(III) subsequently curing the applied composition by heating under pressure at a temperature equal to, or greater than, the melting point of the indium powder, and preferably at a temperature within a range from 160 to 190°C, and even more preferably from 170 to 180°C.

### <Sample Electronic Device>

The electronic device and the method of producing the device are described with reference to Fig. 1, which is a schematic longitudinal cross-sectional view showing a semiconductor device as one example of the electronic device. The device shown in Fig. 1 is merely one example of the application of a composition of the present invention to a semiconductor device, and an electronic device according to the present invention is in no way restricted by the device shown in Fig. 1.

As shown in Fig. 1, this semiconductor device comprises an IC package 2 such as a CPU mounted on top of a printed wiring board 3, and a heat conductive member 1 produced by curing a heat conductive silicone grease composition disposed between the IC package 2 and a heat radiating member 4. The heat radiating member 4 has fins in order to increase the surface area and improve the heat radiating effect. Furthermore, the heat radiating member 4 and the printed wiring board 3 are held together under pressure by a clamp 5.

A method of producing this semiconductor device is described below.

First, the composition is used to fill an application tool such as a syringe. In those cases where the composition has been stored in a frozen state, the composition is placed at room temperature and allowed to thaw naturally to a grease-like state prior to use.

The composition is then discharged from the syringe or the like, and applied (dispensed) onto the surface of the IC package 2 mounted on top of the printed wiring board 3, thus forming a composition layer 1. The heat radiating member 4 is then mounted on top of the composition layer 1, and the clamp 5 is used to pressure-bond and secure the heat radiating member 4 to the IC package 2 via the composition layer 1.

Subsequently, the device is passed, in this pressurized state, through a heating device such as a reflow oven, thereby curing the composition layer 1 and forming the heat conductive member 1. The temperature conditions required during this curing step must be equal to, or greater than, the melting point of the indium powder contained within the composition, and are preferably within a range from 160 to 190°C, and even more preferably from 170 to 180°C. If this curing temperature is less than the melting point of the indium powder, then the melting of the indium powder may be inadequate, whereas if the curing temperature is too high, there is a danger of causing degradation of the electronic component or the substrate.

During curing, the clamp 5 is adjusted so that the thickness of the heat conductive member 1 sandwiched between the IC package 2 and the heat radiating member 4 typically falls within a range from 5 to 30 µm, and is preferably from 10 to 25 µm. If this thickness is overly thin, then the ability of the composition of the present invention to conform to, and follow the surfaces of the IC package 2 and the heat radiating member 4 may be unsatisfactory, meaning there is a danger of gaps appearing between the IC package 2 and the heat radiating member 4. In contrast, if the member is overly thick, then the thermal resistance increases, meaning a satisfactory heat radiating effect may not be obtainable.

During the process of raising the temperature of the composition to the temperature conditions described above, as described above in the section entitled "Curing Method", the indium particles (C-1), or the indium particles (C-1) and the other heat conductive filler (C-2), interconnect to form a type of heat conductive pathway. These heat conductive pathways are fixed and supported within the three dimensional cross-linked structure of the cured product formed by the addition reaction between the component (A) and the component (B). In addition, the liquid indium particles (C-1) also fuse to the surfaces of the neighboring IC package 2 and heat radiating member 4. Accordingly, the IC package 2 and the heat radiating member 4 are linked together via a type of interconnected heat conductive pathway formed by the liquid indium particles (C-1) (and the heat conductive filler (C-2) in some cases), and consequently exhibit a superior level of integrally linked thermal conductivity.

During operation or use of an electronic device such as a semiconductor device produced in this manner, the surface temperature of the electronic component such as an IC package typically reaches a temperature of approximately 60 to 120°C. The heat conductive member comprising the cured product of the composition of the present invention displays excellent thermal conductivity of this generated heat, and produces heat radiating characteristics that are markedly superior to those of conventional heat conductive sheets or heat conductive greases. Moreover, even when the electronic device such as a semiconductor device is operated or used continuously over extended periods, because the component (C-1) and the component (C-2) that are contained within the heat conductive member and form the aforementioned heat conductive pathways are fixed and supported within the three dimensional cross-linked network structure of the cured product, no leakage occurs from the heat conductive member.

Moreover the heat conductive member also exhibits tackiness, so that even if the heat radiating member is slightly offset, or even after extended usage, the conductive member maintains a stable level of flexibility, and is unlikely to separate from either the electronic component or the heat radiating member.

Similar effects can also be achieved by preparing in advance a sheet-like cured product of a desired thickness using a composition of the present invention, and then sandwiching this sheet between an electronic component and a heat radiating member in a similar manner to a conventional heat conductive sheet. In addition, a cured sheet or the like of a composition of the present invention can also be used as a component within other devices that require favorable thermal conductivity and heat resistance.

### EXAMPLES

As follows is a more detailed description of the present invention, based on a series of examples, although the present invention is in no way restricted by the examples presented.

First, the components (A) through (F) that are used in the following examples and comparative examples are listed below.

### <Component (A)>

- (A-1) A dimethylpolysiloxane with both molecular chain terminals blocked with dimethylvinylsiloxy groups, and with a viscosity at 25°C of 0.6 Pa·s
- (A-2) A dimethylpolysiloxane with both molecular chain terminals blocked with dimethylvinylsiloxy groups, and with a viscosity at 25°C of 30.0 Pa·s

### <Component (B)>

- (B-1) The organohydrogenpolysiloxane represented by a structural formula shown below.

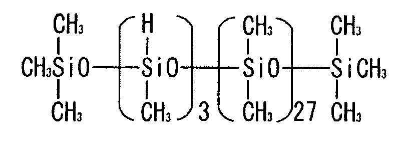

### <Component (C)>

### - Component (C-1) -

(C-1a) Indium powder with an average particle size of 18.4 µm [melting point: 156.7°C]
(C-1b) Indium powder with an average particle size of 47.6 µm [melting point: 156.7°C]

### - Component (C-2) -

(C-2a) Aluminum powder [average particle size: 7.4 µm, mesh-classified product]
(C-2b) Aluminum powder [average particle size: 1.5 µm, mesh-classified product]
(C-2c) Zinc oxide powder [average particle size: 1.0 µm, air flow-classified product]
(C-2d) Copper powder [average particle size: 60.2 µm, unclassified] <for comparison>

### <Component (D)>

- (D-1) A dimethylpolysiloxane (with both molecular chain terminals blocked with dimethylvinylsilyl groups, and with a viscosity at 25°C of 0.6 Pa·s) solution of a platinum-divinyltetramethyldisiloxane complex [platinum atom content: 1% by mass]

### <Component (E)>

- (E-1) A 50% by mass toluene solution of 1-ethynyl-1-cyclohexanol

### <Component (F)>

- (F-1) The organosilane represented by the structural formula: C₁₂H₂₅Si(OCH₂CH₃)₃
- (F-2) The dimethylpolysiloxane with one molecular chain terminal blocked with a trimethoxysilyl group, represented by a structural formula shown below.

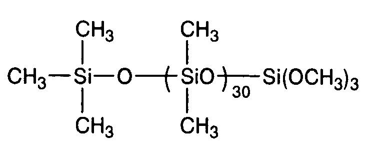

### <Measurement and Inspection of Component (C-1) and Component (C-2)>

The average particle sizes of the component (C-1) and the component (C-2) are cumulative average sizes on a volume basis, and were measured using a particle size analyzer (brand name: Microtrac MT3300EX, manufactured by Nikkiso Co., Ltd.).

Furthermore, the sieve retention particle proportions for the components (C-2) were inspected and measured using the method described below.

### [Visual Inspection of sieve retention particles for 45 µm mesh]

Separate 50 g samples of the components (C-2) were each dissolved in 100 g of toluene, placed in a 200 ml plastic bottle that was then sealed with a stopper, and then either shaken or subjected to ultrasound dispersion until the particles had dispersed completely. Following dispersion, the resulting dispersion was poured through a test sieve (a standard sieve: JIS Z8801-1) with a 45 µm mesh and washed through thoroughly with toluene, and the entire sieve was then placed in a dryer and dried. Following drying, the coarse particles retained on the test sieve were transferred to a sheet of medicine-wrapping paper, and were then inspected visually and evaluated using the evaluation criteria shown below.
O: No coarse particles were visible on the 45 µm mesh sieve
x: Coarse particles were visible on the 45 µm mesh sieve

### [Measurement of mass of sieve retention particles for 32 µm mesh]

Separate 50 g samples of those components (C-2) for which no coarse particles were observed in the visual inspection for 45 µm mesh sieve retention particles were each dissolved in 100 g of toluene, placed in a 200 ml plastic bottle that was then sealed with a stopper, and then either shaken or subjected to ultrasound dispersion until the particles had dispersed completely. Following dispersion, the resulting dispersion was poured through a test sieve (a standard sieve: JIS Z8801-1) with a 32 µm mesh and washed through thoroughly with toluene, and the entire sieve was then placed in a dryer and dried. Following drying, the coarse particles retained on the test sieve were transferred to a sheet of medicine-wrapping paper, the mass was measured, and the resulting mass value was used to calculate the ratio (ppm) of the mass of particles retained on the 32 µm mesh sieve relative to the total mass of the component (C-2).

The inspection and measurement results of the sieve retention particles for the components (C-2) used in the examples and the comparative examples are shown in Table 1.

**Table 1**

| Component | C-2a | C-2b | C-2c | C-2d |
|---|---|---|---|---|
| Sieve retention ratio for 45 µm mesh (visual inspection) | O | O | O | × |
| Sieve retention ratio for 32 µm mesh (ppm) | 41 | 29 | 8 | - |

| | | | | |
|---|---|---|---|---|
| * For the component (C-2d), because the inspection result for sieve retention on the 45 µm mesh was ×, the sieve retention ratio for the 32 µm mesh was not measured. | | | | |

### [Examples 1 to 5, Comparative Examples 1 to 4]

### <Preparation of Compositions>

Using the compounds and blend quantities shown in Table 2 and Table 3, compositions were prepared in the manner described below.

In a planetary mixer with an internal capacity of 700 ml (product name: T.K. Hivis Mix, manufactured by Tokushu Kika Kogyo Co., Ltd.) were placed the component (A), the component (C), and the component (F), and the temperature was then raised to 70°C and held at that temperature while mixing was conducted for 60 minutes. Subsequently, the mixing was halted and the temperature was cooled to 25°C. The component (B), the component (D), and the component (E) were then added, and mixing was conducted to prepare a uniform composition.

The viscosity (Pa·s) at 25°C of each of the compositions prepared in this manner (excluding the compositions of the comparative example 1 and the comparative example 2) was measured using a Malcolm viscometer (model: PC-1T, manufactured by Malcolm Co., Ltd.). The resulting viscosity values are shown in Table 2 and Table 3.

### <Preparation of Cured Products>

0.2 g of each of the compositions obtained above (excluding those of the comparative example 1 and the comparative example 2) was applied across the entire surface of a standard circular nickel plate (purity: 99.9%, diameter: approximately 12.7 mm, thickness: approximately 1.0 mm), another standard nickel plate was placed on top, and the resulting structure was then squeezed together with a clip under a pressure of approximately 175.5 kPa (1.80 kgf/cm²), thereby forming a 3-layer structure. This 3-layer structure was then placed inside an electric oven, with the pressure from the clip still applied, the temperature was raised to 175°C, this temperature was maintained for 90 minutes to cure the composition, and the structure was then left to cool to room temperature, thus completing the preparation of a test sample for the measurement of thermal resistance.

The thickness of each of these test samples was measured, and the thickness of the cured product was calculated by subtracting the known thickness for the standard nickel plates. A micrometer (model: M820-25VA, manufactured by Mitutoyo Corporation) was used for the measurement of the thickness values for each of the test samples. The results are shown in Table 2 and Table 3.

### <Measurement of Thermal Resistance>

Using the above test samples, the thermal resistance (mm²·K/W) of each cured product was measured at 25°C using a thermal resistance measuring device (a xenon flash analyzer: LFA447 NanoFlash, manufactured by Netzsch GmbH) based on the laser flash method. The resulting thermal resistance values are shown in Table 2 and Table 3.

### <Application to Semiconductor Devices>

0.2 g of each of the compositions obtained in the examples 1 through 5 was applied to the surface of a 2 cm x 2 cm CPU to form a composition layer. A heat radiating member was then overlaid and pressure-bonded to the composition layer, and with the structure held under pressure, the composition was cured by heating in the same manner as that described above in the section entitled "Preparation of Cured Products", thus yielding a semiconductor device in which the CPU and the heat radiating member were bonded together via a heat conductive member with a thickness of 10 to 30 µm. Each of the produced devices was installed in a host computer or a personal computer or the like and operated, and even though the output temperature of the CPU was approximately 100°C, all of the devices were able to be used over an extended period, with stable thermal conductivity and heat radiation, and potential problems such as deterioration in the CPU performance or device failure caused by excessive heat accumulation were able to be prevented. Accordingly, it was confirmed that employing a cured product of a composition of the present invention enables an improvement in the reliability of a semiconductor device.

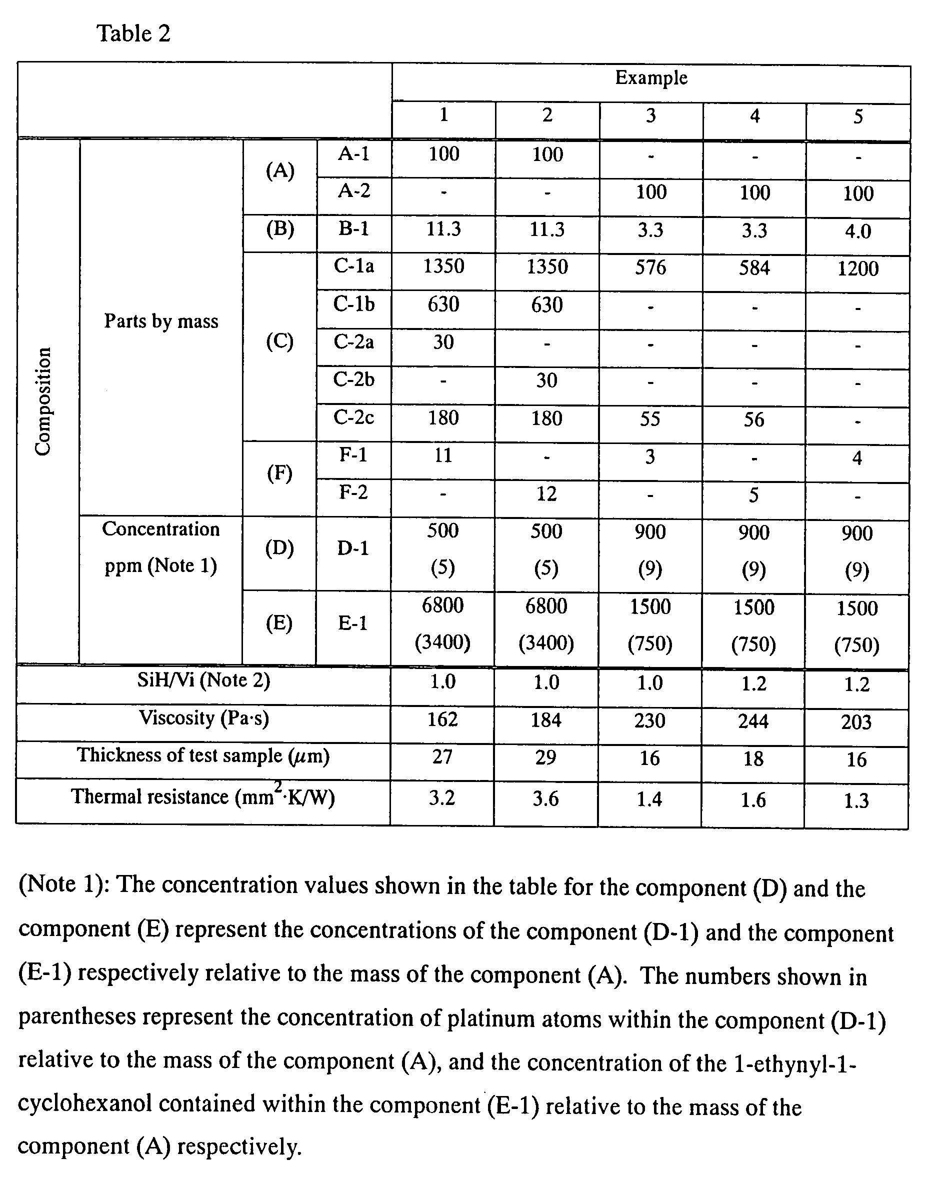

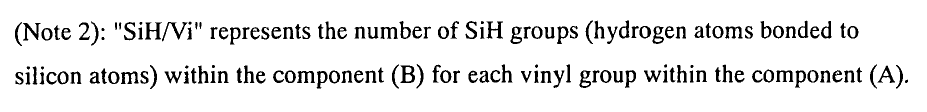

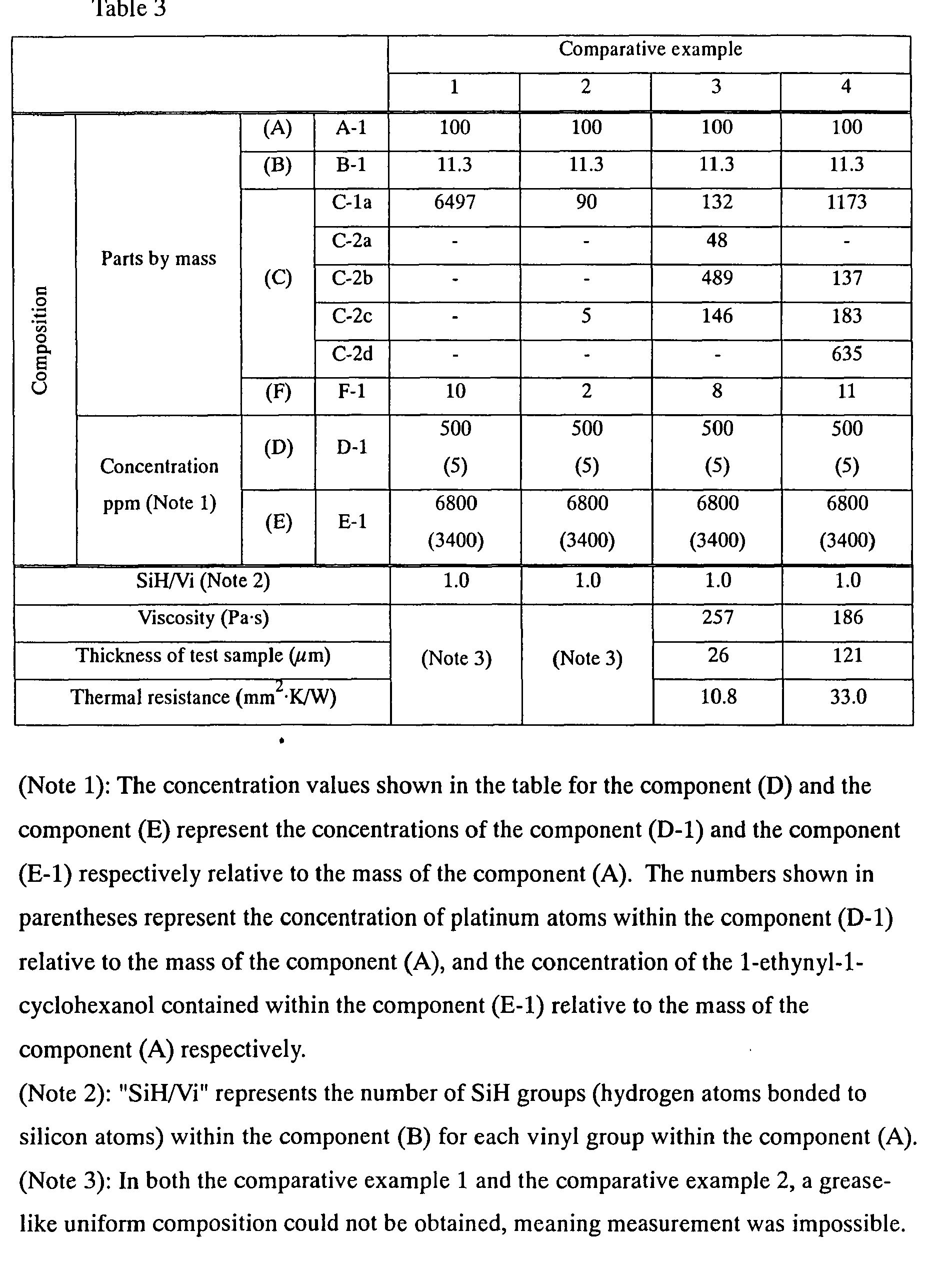

## Claims

1. A heat conductive silicone grease composition comprising:
(A) 100 parts by mass of an organopolysiloxane containing 2 or more alkenyl groups bonded to silicon atoms within each molecule,
(B) an organohydrogenpolysiloxane containing 2 or more hydrogen atoms bonded to silicon atoms within each molecule, in sufficient quantity to provide from 0.1 to 5.0 hydrogen atoms bonded to silicon atoms within said component (B) for each alkenyl group within said component (A),
(C) 100 to 2,200 parts by mass of a heat conductive filler,
(D) an effective quantity of a platinum-based catalyst, and
(E) an effective quantity of an addition reaction retarder, wherein
said heat conductive filler of said component (C) comprises more than 90% by mass and no more than 100% by mass of an indium powder with an average particle size of 0.1 to 100 µm.

2. The composition according to claim 1, wherein said indium powder has an average particle size within a range from 5 to 50 µm.

3. The composition according to claim 1, wherein said heat conductive filler of said component (C) comprises 91 to 100% by mass of said indium powder.

4. The composition according to claim 1, wherein said heat conductive filler of said component (C) also comprises more than 0% by mass but less than 10% by mass of another heat conductive filler besides said indium powder, and said other heat conductive filler has an average particle size within a range from 0.1 to 20 µm, a sieve retention ratio for a 32 µm mesh prescribed in JIS Z8801-1 of no more than 50 ppm relative to the total mass of said other heat conductive filler, and a sieve retention ratio for a 45 µm mesh prescribed in JIS Z8801-1 that is effectively 0 ppm relative to the total mass of said other heat conductive filler.

5. The composition according to claim 4, wherein said other heat conductive filler is at least one selected from the group consisting of metal powders, metal oxide powders, metal nitride powders, diamond powder and carbon powder.

6. The composition according to claim 4, wherein said other heat conductive filler is at least one selected from the group consisting of aluminum powder, nickel powder, zinc powder, stainless steel powder, copper powder, silver powder, alumina powder, zinc oxide powder, boron nitride powder, aluminum nitride powder, silicon nitride powder, diamond powder and carbon powder.

7. The composition according to claim 1, further comprising:
(F-1) 0.01 to 20 parts by mass of an alkoxysilane compound represented by a general formula (3) shown below:
R⁴ₐR⁵_{b}Si(OR⁶)_{4-a-b} (3)
(wherein, each R⁴ represents, independently, an alkyl group of 6 to 15 carbon atoms, each R⁵ represents, independently, an unsubstituted or substituted monovalent hydrocarbon group of 1 to 8 carbon atoms, each R⁶ represents, independently, an alkyl group of 1 to 6 carbon atoms, a represents an integer from 1 to 3, b represents an integer from 0 to 2, and a sum of a+b is an integer from 1 to 3), and/or
(F-2) 0.01 to 20 parts by mass of a dimethylpolysiloxane in which one molecular chain terminal is blocked with a trialkoxysilyl group, represented by a general formula (4) shown below: 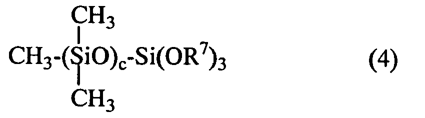 (wherein, each R⁷ represents, independently, an alkyl group of 1 to 6 carbon atoms, and c represents an integer from 5 to 100).

8. The composition according to claim 1, wherein the viscosity at 25°C of said composition is within a range from 10 to 1,000 Pa·s.

9. A heat conductive silicone cured product obtained by curing the composition defined in claim 1 by heating at a temperature equal to, or greater than, a melting point of said indium powder.

10. The cured product according to claim 9, wherein said temperature is within a range from 160 to 190°C.

11. The cured product according to claim 9, wherein the thermal resistance at 25°C of said cured product measured by a laser flash method is no more than 10 mm²·K/W.

12. An electronic device comprising an electronic component, a heat radiating member, and a heat conductive member comprising a cured product defined in claim 10 disposed between said electronic component and said heat radiating member.

13. The electronic device according to claim 12, wherein said heat conductive member is in the form of a layer with a thickness of no more than 30 µm.

14. A method of curing the composition defined in claim 1, comprising the step of heating said composition under pressure at a temperature equal to, or greater than, a melting point of said indium powder.

15. The method according to claim 14, wherein said pressure is within a range from 50 to 1,500 kPa.

16. The method according to claim 14, wherein said temperature is within a range from 160 to 190°C.

17. A method of forming a heat conductive member between an electronic component and a heat radiating member, comprising the steps of:
(I) applying the composition defined in claim 1 to a surface of said electronic component,
(II) mounting said heat radiating member on said applied composition, and
(III) subsequently curing said applied composition by heating said composition under pressure at a temperature equal to, or greater than, a melting point of said indium powder.

18. The method according to claim 17, wherein said pressure is within a range from 50 to 1,500 kPa.

19. The method according to claim 17, wherein said temperature is within a range from 160 to 190°C.
